# EUROPÄISCHE PATENTSCHRIFT

(11) **EP 4 119 957 B1**
(45) Veröffentlichungstag und Bekanntmachung des Hinweises auf die Patenterteilung: **17.06.2026**
(21) Anmeldenummer: 21185964.0
(22) Anmeldetag: 16.07.2021
(51) Int. Cl.: G01R 31/26, H02H 3/04, H02H 3/02

(54) **VERFAHREN ZUM ÜBERWACHEN EINER SCHUTZEINRICHTUNG**
METHOD FOR MONITORING A PROTECTIVE DEVICE
PROCÉDÉ DE SURVEILLANCE D'UN DISPOSITIF DE PROTECTION

(43) Veröffentlichungstag der Anmeldung: 18.01.2023
(73) Patentinhaber: Siemens Energy Global GmbH & Co. KG, 81739 München (DE)
(72) Erfinder: Stahlhut, Nils, 91341 Röttenbach (DE)

(56) Entgegenhaltungen:
- EP-A1- 0 249 123
- EP-A1- 2 937 705
- WO-A1-94/06028
- DE-A1- 3 627 114
- "IEEE Standard for Series Capacitor Banks in Power Systems;IEEE Std 824-2004 (Revision of IEEE Std 824-1994) ED - Anonymous", IEEE STANDARD; [IEEE STANDARD], IEEE, PISCATAWAY, NJ, USA, 1 January 2005 (2005-01-01), pages _1 - 53, XP017694292, ISBN: 978-0-7381-4530-3

## Beschreibung

Die Erfindung betrifft ein Verfahren zum Überwachen einer Schutzeinrichtung, die eine Reihenschaltung einer Vielzahl von Thyristoren aufweist.

Es ist bekannt, zum Schutz von elektrischen Einrichtungen Thyristoren einzusetzen. Eine Reihenschaltung der Thyristoren samt einer zugehörigen Beschaltung wird oftmals als Thyristorventil bezeichnet. Solche Thyristorventile in Schutzanwendungen zeichnen sich dadurch aus, dass sie in der Regel parallel zu den zu schützenden Betriebsmitteln angeordnet sind und den Betriebsstrom nur im Fehlerfall bzw. temporär führen. Die and den Thyristoren anliegende Spannung entspricht in ihrer Form der Netzspannung und ist näherungsweise Sinusförmig. Die Sperreigenschaften der Thyristoren lassen sich anhand von einzelnen Thyristorspannungen kontinuierlich überwachen, defekte Halbleiter können jeder Zeit detektiert werden.

Aus der EP 2 937 705 A1 sind eine Vorrichtung und ein Verfahren zum Testen von Thyristoren einer Thyristor-Reihenschaltung bekannt, bei dem die Thyristoren zur Überprüfung ihrer Funktionsfähigkeit nacheinander gezündet werden.

Eine weitere Vorrichtung zum Testen von Thyristoren eines Thyristorventils ist in der WO we- 94/06028 A1 beschrieben.

Die Aufgabe der Erfindung ist es, ein artgemäßes Verfahren vorzuschlagen, mit dem eine verbesserte Überwachung der Schutzeinrichtung ermöglicht.

Die Aufgabe wird durch ein Verfahren nach Anspruch 1 zum Überwachen einer Schutzschaltung gelöst, wobei die Schutzschaltung eine Reihenschaltung von N>1 Thyristoren aufweist, die in einer Parallelschaltung zu einer zu schützenden elektrischen Einrichtung geschaltet ist, wobei jedem Thyristor ein Beschaltungszweig parallelgeschaltet ist, bei dem zwecks Überprüfung einer Zündfähigkeit n<N Thyristoren einer ersten Thyristorgruppe gezündet werden, wenn an der Reihenschaltung eine positive Spannung anliegt, und ein negativer Beschaltungsstrom durch die Beschaltungszweige der Thyristoren der ersten Thyristorgruppe fließt (dieser Beschaltungsstrom kann auch als erster Beschaltungsstrom bezeichnet werden). Die Anzahl N der Thyristoren kann je nach Anwendung variieren, ebenso die Anzahl n der Thyristoren der ersten Thyristorgruppe. Der Beschaltungszweig für jeden Thyristor umfasst geeigneterweise eine sogenannte Beschaltungsgruppe, die zum Beispiel ein R-C-Glied ("RC snubber") aufweisen kann, das zu einer Dämpfung von Schaltvorgängen dient. Die Schutzeinrichtung umfasst zweckmäßigerweise wenigstens eine Zündschaltung, die zum Zünden der Thyristoren der Reihenschaltung wenigstens eine Zündschaltung vorgesehen ist. Die Zündschaltung kann beispielsweise eine elektrische Zündung oder eine Lichtzündung ermöglichen. Die Polarität der Spannung an der Reihenschaltung (positiv bzw. negativ) ist im Sinne der Erfindung auf die Durchlassrichtung der Thyristoren der Reihenschaltung bezogen. Gleiches gilt auch für den Strom. Die Überwachungszündungen werden zweckmäßigerweise zu einem Zeitpunkt ausgelöst, an dem die jeweiligen Zündbedingungen an den betrachteten Thyristoren erfüllt sind (Spannung positiv, Strom im Beschaltungszweig negativ). Diese Bedingungen sind beispielsweise zwischen einem positiven Scheitel und einem Nulldurchgang einer an der Reihenschaltung anliegenden Systemspannung erfüllt. In Anwendungen mit einer Verwendung antiparalleler Thyristoren kann die Reihenschaltung auch als die erste Reihenschaltung bezeichnet werden.

Die Erfindung ermöglicht es vorteilhaft, die Zündfähigkeit der Schutzeinrichtung zu überprüfen bzw. überwachen, ohne deren Abschaltung, d.h. im laufenden Betrieb. Die Zündfähigkeit jedes einzelnen Thyristors kann bei anliegender Betriebsspannung, aber ohne Betriebsstrom überwacht werden. Durch die Erfindung lässt sich demnach die Verfügbarkeit der Schutzeinrichtung (insbesondere des Thyristorventils) steigern, da damit insgesamt der vollständige Ansteuerpfad bis zum Leistungshalbleiter (Thyristor) kontinuierlich überwacht werden kann. Die notwendigen Hardwarekomponenten sind üblicherweise bereits vorhanden, es muss lediglich eine Implementierung und Absicherung der Funktion in Steuerung/Regelung erfolgen, so dass das Verfahren einfach und kostengünstig implementierbar ist.

Erfindungsgemäß werden zeitlich dem Zünden der ersten Thyristorgruppe nachgeordnet m<N Thyristoren einer zweiten Thyristorgruppe gezündet, wenn an der zweiten Thyristorgruppe eine positive Spannung anliegt (die auch als zweite Gruppenspannung bezeichnet werden kann), und ein negativer Beschaltungsstrom durch die Beschaltungszweige der Thyristoren der zweiten Thyristorgruppe fließt (dieser Beschaltungsstrom kann auch als zweiter Beschaltungsstrom bezeichnet werden). Erfindungsgemäß wird dies innerhalb der gleichen Spannungshalbperiode durchgeführt. Vorzugsweise werden die Thyristoren der zweiten Thyristorgruppe gezündet, wenn die an der Reihenschaltung eine nichtnegative Spannung anliegt (die im Übrigen auch als Anschlussspannung bezeichnet werden kann). Das Zünden der Thyristoren der zweiten Thyristorgruppe erfolgt dann, wenn die Anschlussspannung ihren Nulldurchgang durchläuft bzw. im Nulldurchgang ist. Die Anzahl n und die Anzahl m können derart gewählt werden, dass n + m = N gilt, was aber nicht notwendig ist. Es muss jeweils lediglich gewährleistet sein, dass die an der Reihenschaltung anliegende Spannung zum Zeitpunkt der Zündung von den nicht gezündeten bzw. nicht aktivierten Thyristoren gehalten werden kann. Die Thyristorgruppen (bzw. deren Thyristoren) des Thyristorventils werden somit getrennt voneinander gezündet, ohne dass die gesamte Reihenschaltung bzw. das gesamte Thyristorventil vollständig leitend wird. Das Einschalten der Thyristoren kann grundsätzlich beispielsweise durch Detektieren eines Unterschreitens von festgelegten Spannungsschwellen, geeigneterweise in einem vordefinierten Zeitfenster, detektiert werden.

Geeigneterweise wird jeder Thyristor der Reihenschaltung einer von i>1 Thyristorgruppen mit jeweils ni Thyristoren zugeordnet, wobei alle Thyristorgruppen zeitlich nacheinander gezündet werden. Auf diese Weise ist eine Überwachung aller Thyristoren ermöglicht. Vorzugsweise ist die Anzahl ni der Thyristoren aller Thyristorgruppen gleich.

Gemäß einer Ausführungsform der Erfindung wird das Verfahren in einem zeitlichen Abstand von mindestens 1h wiederholt durchgeführt. Für manche Anwendungen kann eine Wiederholung in Abständen von einem Tag geeignet sein. Für manche Anwendungen kann eine Wiederholung nach Aufforderung geeignet sein. Auf diese Weise ist eine relativ kontinuierliche Überwachung der Funktionsfähigkeit der Schutzeinrichtung ermöglicht.

Bevorzugt wird eine Information über ein Zündergebnis an eine Überwachungseinheit übermittelt wird und im Falle einer detektierten Fehlfunktion eines der Thyristoren (eine Fehlfunktion einer zugeordneten Zündanordnung mitbetrachtet) eine Fehlermitteilung generiert wird. Das Zündergebnis ist im Falle einer erfolgreichen Zündung des betreffenden Thyristors oder auch einer erfolgreichen Zündung der gesamten Thyristorgruppe positiv. Bei einem negativen Zündergebnis kann die Fehlfunktion festgestellt werden. Die Information über das Einschalten bzw. Nicht-Einschalten eines Thyristors wird beispielsweise von einer Überwachungseinheit (bsp. einem Thyristor Voltage Monitoring, TVM) über Lichwellenleiter an eine Auswerteeinheit (bsp. eine Fußpunktelektronik), vorzugsweise auf Erdpotenzial angeordnet, weitergeleitet und dort ausgewertet.

Gemäß einer Ausführungsform der Erfindung umfasst die Schutzeinrichtung eine weitere Reihenschaltung von N Thyristoren, wobei die Thyristoren der Reihenschaltung und die Thyristoren der weiteren Reihenschaltung antiparallel zueinander angeordnet sind. Durch diese Anordnung ist die Schutzeinrichtung für einen Schutz unabhängig von der Stromrichtung eingerichtet. Das Verfahren kann auch bezüglich der weiteren Reihenschaltung angewandt werden, so dass auch die antiparallelen Thyristoren auf ihre Zündfähigkeit überwacht werden können. Zwecks Überprüfung ihrer Zündfähigkeit können p<N Thyristoren einer weiteren Thyristorgruppe der weiteren Reihenschaltung gezündet werden, wenn an der weiteren Reihenschaltung eine negative Spannung anliegt, und ein positiver (erster) Beschaltungsstrom durch die Beschaltungszweige der Thyristoren der weiteren Thyristorgruppe fließt (die Beschaltungszweige der Thyristoren der weiteren Thyristorgruppe sind geeigneterweise identisch mit den Beschaltungszweigen der Thyristoren der ersten Thyristorgruppe). Die Spannung und der Strom sind dabei, um Mehrdeutigkeit zu vermeiden, wiederum bezüglich der Durchlassrichtung der Thyristoren der ersten Reihenschaltung zu verstehen. Die Thyristoren der weiteren Reihenschaltung können beispielsweise auf mehrere Thyristorgruppen aufgeteilt werden und diese nacheinander gezündet werden, vorzugsweise wie zuvor bezüglich der Reihenschaltung (bzw. der ersten und zweiten Thyristorgruppe) beschrieben. Die Überprüfung der Zündfähigkeit der Thyristoren der weiteren Reihenschaltung wird aber nicht zeitgleich mit der Überprüfung der Zündfähigkeit der Thyristoren der Reihenschaltung, sondern beispielsweise in nachfolgenden Netzperioden durchgeführt.

Gemäß einer Ausführungsform der Erfindung werden die Thyristoren mittels einer Lichtzündung gezündet. Bei dieser Variante kann vorteilhaft der gesamte Signalpfad einschließlich des Thyristors überwacht werden.

Vorzugsweise ist die elektrische Einrichtung ein Kurzschlussstrombegrenzungseinrichtung (SCCL, Short Circuit Current Limiter) oder eine kapazitive Kompensationseinrichtung (TPSC, Thyristor Protected Series Capacitor). Diese Einrichtungen sind besonders Systemkritisch, so dass eine Erhöhung ihrer Zuverlässigkeit durch den verbesserten Schutz mittels der Schutzeinrichtung und somit auch mittels des erfindungsgemäßen Verfahrens besonders vorteilhaft ist.

Die Erfindung wird nachfolgend anhand der Figuren 1 bis 5 weiter erläutert.
Figur 1 zeigt eine Schutzeinrichtung in einer schematischen Darstellung;
Figuren 2 und 3 zeigen jeweils Verlaufsdiagramme für Spannung und Strom im Zusammenhang mit einem Beispiel eines Verfahrens, das nicht der Erfindung entspricht;
Figuren 4 und 5 zeigen jeweils Verlaufsdiagramme für Spannung und Strom im Zusammenhang mit einer Variante eines erfindungsgemäßen Verfahrens.

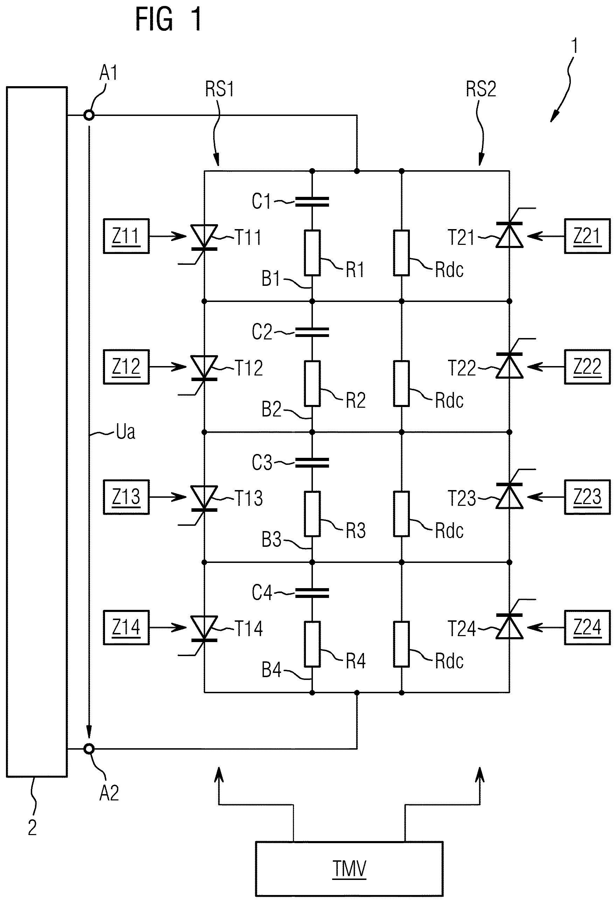

In Figur 1 ist eine Schutzeinrichtung 1 dargestellt. Die Schutzeinrichtung 1 dient zu einem Schutz einer elektrischen Einrichtung 2, wobei die Schutzeinrichtung 1 in einer Parallelschaltung zu der zu schützenden elektrischen Einrichtung 2 angeordnet und mit dieser über Anschlüsse A1 und A2 verbunden ist. Eine zwischen den beiden Anschlüssen A1, A2 anstehende Anschlussspannung wird mit Ua bezeichnet. In einem Fehlerfall soll die Schutzeinrichtung 1 einen Fehlerstrom durch die Einrichtung 2 übernehmen. Dazu umfasst die Schutzeinrichtung 1 Thyristoren T11-T14, die eine Reihenschaltung RS1 ausbilden, sowie T21-T24, die eine weitere Reihenschaltung RS2 ausbilden, die in einem Fehlerfall gezündet werden können. Dabei sind die Thyristoren T11-T14 den Thyristoren T21-T24 antiparallel geschaltet, so dass die Schutzeinrichtung ihre Schutzfunktion unabhängig von der Stromrichtung ausüben kann. Jedem Thyristor T11-T24 bzw. jedem antiparallelen Thyristor-Paar T11/T21-T14/T24 ist ein Beschaltungszweig (snubber-Glied) B1-B4 zugeordnet. Die Beschaltungszweige B1-B4 sind jeweils in Reihe zueinander und parallel zu den Thyristoren geschaltet und umfassen jeweils ein Kapazitätselement C1-C4 und ein Widerstandselement R1-R4.

Zum Zünden der Thyristoren T11-T24 sind Zündschaltungen Z11-Z24 vorgesehen. Mittels einer Überwachungseinheit TVM werden die Thyristoren T11-T24 und insbesondere eine jeweils an den Thyristoren T11-T24 anstehenden Thyristorspannungen überwacht.

In dem in Figur 1 dargestellten Beispiel bilden die Thyristoren T11,T12 eine erste Thyristorgruppe, die Thyristoren T13,T14 eine zweite Thyristorgruppe, die Thyristoren T21,T22 eine dritte Thyristorgruppe und die Thyristoren T23,T24 eine vierte Thyristorgruppe.

Parallel zu jedem Beschaltungszweig B1-B4 ist jeweils ein DC Steuerwiderstand (DC Grading Resistor) Rdc angeordnet. Der DC Steuerwiderstand Rdc ist ein hochohmiger Widerstand, der dazu dient, DC Verschiebungen langfristig abzubauen.

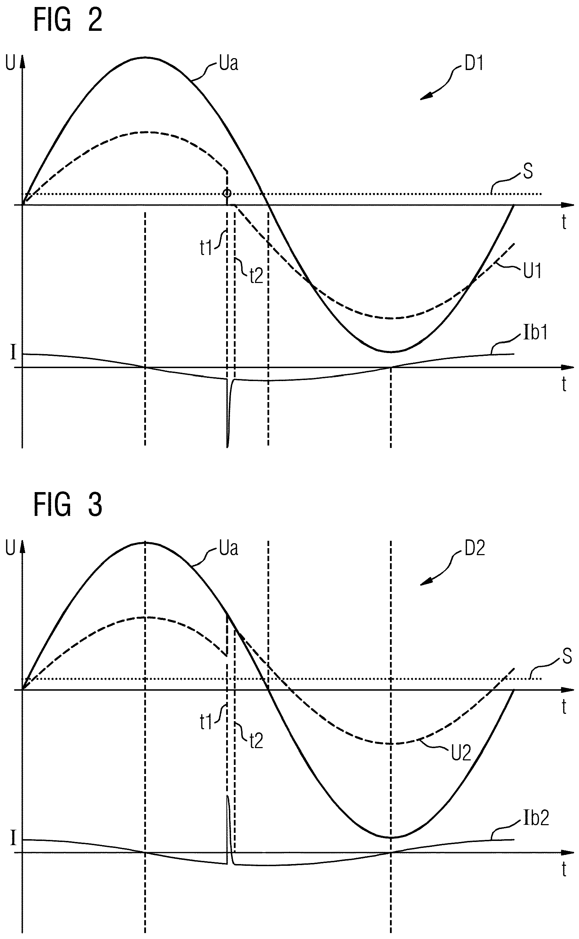

Anhand eines Diagramms D1 der Figur 2 wird nun die Vorgehensweise bei einem Beispiel eines Verfahrens, das nicht der Erfindung entspricht , beschrieben. Das Diagramm D1 zeigt eine waagerechte Zeitachse t und eine senkrechte Spannungs- bzw. Stromachse U bzw. I. Der (zeitliche) Verlauf der Anschlussspannung ist mit Ua gekennzeichnet. Der Verlauf einer an der ersten Thyristorgruppe T11, T12 anstehenden ersten Gruppenspannung ist mit U1 gekennzeichnet. Ein Strom durch die Beschaltungszweige B1, B2 ist mit Ib1 gekennzeichnet.

Zur Überprüfung der Zündfähigkeit der Thyristoren T11, T12 der ersten Thyristorgruppe werden diese zum Zeitpunkt t1 gezündet. Zu diesem Zeitpunkt ist die Anschlussspannung Ua positiv, der Strom Ib1 durch die Beschaltungszweige (erster Beschaltungsstrom) negativ. Entsprechend entladen sich die Kapazitätselemente C1 und C2 über die gezündeten Thyristoren T11 und T12, da sie nun kurzgeschlossen sind. Der negative erste Beschaltungsstrom Ib1 ist also von einem bezogen auf die Durchlassrichtung der Thyristoren T11, T12 positiven, durch die Entladung der Kapazitätselemente C1, C2 bedingten Entladestrom überlagert. Die erste Gruppenspannung U1 sinkt und unterschreitet dabei eine Überwachungsschwelle, die mit einer gepunkteten Linie S gekennzeichnet ist. Das Unterschreiten der Überwachungsschwelle kann detektiert werden, so dass eine entsprechende Meldung erzeugt werden kann, dass die Zündung erfolgreich war. Zu einem Zeitpunkt t2 klingt der Entladestrom so weit ab, dass die Thyristoren T11, T12 sperren.

Das Diagramm D2 der Figur 3 zeigt eine waagerechte Zeitachse t und eine senkrechte Spannungs- bzw. Stromachse U bzw. I. Der (zeitliche) Verlauf der Anschlussspannung ist mit Ua gekennzeichnet. Der Verlauf einer an der zweiten Thyristorgruppe T13, T14 anstehenden zweiten Gruppenspannung ist mit U2 gekennzeichnet. Ein Strom durch die Beschaltungszweige B3, B4 ist mit Ib2 gekennzeichnet (zweiter Beschaltungsstrom). Da gemäß dem in den Figuren 1 bis 3 gezeigten Beispiel die Thyristoren T11-T24 gleichartig aufgebaut sind und zudem alle Thyristorgruppen die gleiche Anzahl von Thyristoren umfassen, stimmen die Gruppenspannungen U1 und U2 bis zu einem Zeitpunkt t1 überein.

Es ist ferner erkennbar, dass die Gruppenspannungen U1 und U2 nach dem Zeitpunkt t2 unterschiedlich sind. Bedingt durch die Zündung der ersten Thyristorgruppe T11, T12 erhöht sich die zweite Gruppenspannung U2 entsprechend stufenartig, da nun die gesamte Anschlussspannung Ua an den Thyristoren T13, T14 der zweiten Thyristorgruppe anliegt. Der Anstieg der zweiten Gruppenspannung U2 gegenüber der ersten Gruppenspannung U1 kann u.U. zu einer Überspannung führen.

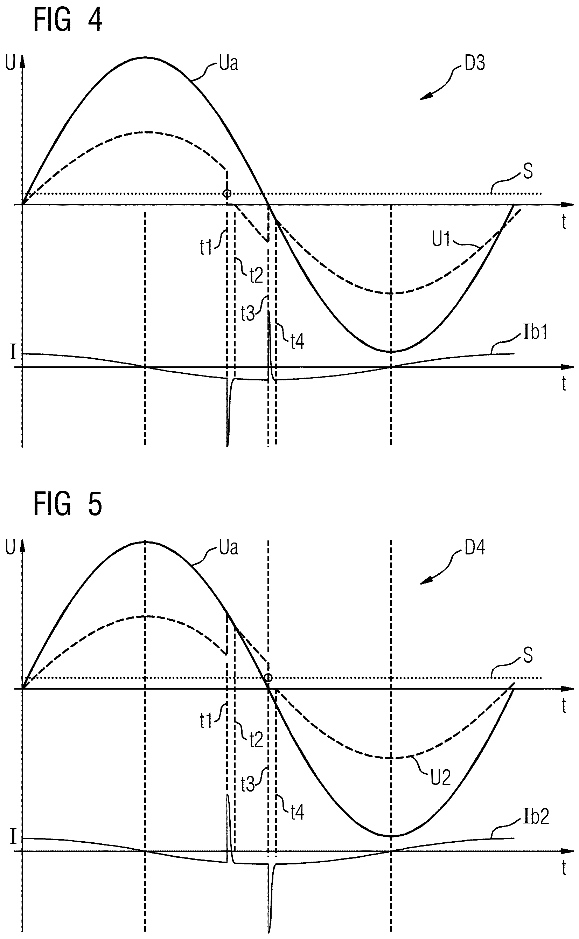

In den Figuren 4 und 5 ist eine vorteilhafte Variante des erfindungsgemäßen Verfahrens dargestellt. Dabei sind zu besseren Übersichtlichkeit gleiche und gleichartige Elemente in den Figuren 2 bis 5 mit gleichen Bezugszeichen versehen. Wie zuvor beschrieben, werden die Thyristoren T11 und T12 zum Zeitpunkt t1 gezündet. Gemäß der Variante der Figuren 4 und 5 werden zu einem Zeitpunkt t3 (zweite Gruppenspannung U2 ist positiv, zweiter Beschaltungsstrom Ib2 ist negativ) zusätzlich auch die Thyristoren T13 und T14 gezündet. Mit dem Zünden der Thyristoren T13, T14 der zweiten Thyristorgruppe sinkt die Gruppenspannung U2 sprungartig (vgl. Figur 5). Dies kann zur Überprüfung der Zündfähigkeit der Thyristoren T13, T14 der zweiten Thyristorgruppe genutzt werden (insbesondere Anhand eines Vergleiches mit der Überwachungsschwelle S). Als Resultat sind zudem die Verläufe der beiden Gruppenspannungen U1 und U2 nach einem Zeitpunkt t4, zu dem die Thyristoren T13, T14 der zweiten Thyristorgruppe sperren, nahezu gleich. Das Risiko einer Überspannung kann auf diese Weise vorteilhaft reduziert werden.

Eine Überwachung der Zündfähigkeit der Thyristoren der weiteren Reihenschaltung RS2 kann in analoger Weise zu der zuvor beschriebenen Vorgehensweise durchgeführt werden. Dabei werden die Thyristoren T21-T24 der dritten und der vierten Thyristorgruppe gezündet, nachdem die Überprüfung der Zündfähigkeit der Thyristoren der Reihenschaltung RS1 durchgeführt wurde, beispielsweise während der nachfolgenden Netzperioden. Es ist dabei zu beachten, dass dazu sowohl die Spannung als auch der Beschaltungsstrom eine geeignete Polarität aufweisen müssen.

## Patentansprüche

1. Verfahren zum Überwachen einer Schutzeinrichtung (1), die eine Reihenschaltung (RS1) von N>1 Thyristoren (T11-T14) aufweist, die in einer Parallelschaltung zu einer zu schützenden elektrischen Einrichtung (2) geschaltet ist, wobei jedem Thyristor (T11-T14) ein Beschaltungszweig (B1-B4) parallelgeschaltet ist, bei dem zwecks Überprüfung einer Zündfähigkeit n<N Thyristoren (T11,T12) einer ersten Thyristorgruppe (T11,T12) gezündet werden, wenn
an der Reihenschaltung (RS1) eine positive Spannung (Ua) anliegt, und
ein negativer Beschaltungsstrom (Ibl) durch die Beschaltungszweige (B1-B2) der Thyristoren (T11,T12) der ersten Thyristorgruppe (T11,T12) fließt, **dadurch gekennzeichnet, dass**
zeitlich dem Zünden der ersten Thyristorgruppe (T11,T12) nachgeordnet, innerhalb der gleichen Spannungshalbperiode, m<N Thyristoren einer zweiten Thyristorgruppe (T13,T14) gezündet werden, wenn
an der zweiten Thyristorgruppe (T13,T14) eine positive Spannung (U2) anliegt, und
ein negativer Beschaltungsstrom (Ib2) durch die Beschaltungszweige (B3-B4) der Thyristoren (T13,T14) der zweiten Thyristorgruppe (T13,T14) fließt, wobei das Zünden der Thyristoren der zweiten Thyristorgruppe dann erfolgt, wenn die an der Reihenschaltung anliegende Spannung ihren Nulldurchgang durchläuft.

2. Verfahren nach Anspruch 1, wobei jeder Thyristor (T11-T14) der Reihenschaltung (RS1) einer von i>1 Thyristorgruppen (T11,T12,T13,T14) mit jeweils ni Thyristoren zugeordnet wird, wobei alle Thyristorgruppen (T11,T12,T13,T14) zeitlich nacheinander gezündet werden.

3. Verfahren nach einem der vorangehenden Ansprüche, wobei die Anzahl ni der Thyristoren aller Thyristorgruppen gleich ist.

4. Verfahren nach einem der vorangehenden Ansprüche, wobei das Verfahren in einem zeitlichen Abstand von mindestens 1h wiederholt durchgeführt wird.

5. Verfahren nach einem der vorangehenden Ansprüche, wobei eine Information über ein Zündergebnis an eine Überwachungseinheit (TVM) übermittelt wird und im Falle einer detektierten Fehlfunktion eines der Thyristoren eine Fehlermitteilung generiert wird.

6. Verfahren nach einem der vorangehenden Ansprüche, wobei die Schutzeinrichtung (1) eine weitere Reihenschaltung (RS2) von N Thyristoren (T21-T24) umfasst, die Thyristoren (T11-T14) der Reihenschaltung (RS1) und die Thyristoren (T21-T24) der weiteren Reihenschaltung (RS2) antiparallel zueinander angeordnet sind.

7. Verfahren nach Anspruch 6, wobei zwecks Überprüfung einer Zündfähigkeit p<N Thyristoren einer weiteren Thyristorgruppe (T21,T22) der weiteren Reihenschaltung (RS2) gezündet werden, wenn an der weiteren Reihenschaltung eine negative Spannung anliegt, und
ein positiver Beschaltungsstrom (Ibl) durch die Beschaltungszweige (B1,B2) der Thyristoren (T21,T22) der weiteren Thyristorgruppe (T21,T22) fließt.

8. Verfahren nach einem der vorangehenden Ansprüche, wobei die Thyristoren (T11-T24) mittels einer Lichtzündung gezündet werden.

9. Verfahren nach einem der vorangehenden Ansprüche, wobei die elektrische Einrichtung (2) ein Kurzschlussstrombegrenzungseinrichtung oder eine kapazitive Kompensationseinrichtung ist.

## Claims

1. A method for monitoring a protective device (1) having a series circuit (RS1) of N>1 thyristors (T11-T14) connected in parallel with an electrical device (2) that is to be protected, each thyristor (T11-T14) being connected in parallel with a snubber branch (B1-B4) in which n<N thyristors (T11,T12) of a first group of thyristors (T11,T12) are fired for checking a firing capability, when
a positive voltage (Ua) is applied to the series circuit (RS1), and
a negative snubber current (Ibl) flows through the snubber branches (B1-B2) of the thyristors (T11,T12) of the first thyristor group (T11,T12),
**characterized in that**
temporally after the firing of the first thyristor group (T11,T12), m<N thyristors of a second thyristor group (T13,T14) are fired within the same voltage half-period, when
a positive voltage (U2) is applied to the second thyristor group (T13,T14), and
a negative snubber current (Ib2) flows through the snubber branches (B3-B4) of the thyristors (T13,T14) of the second thyristor group (T13,T14), the firing of the thyristors of the second thyristor group taking place when the voltage applied to the series connection passes through its passage through zero.

2. The method according to claim 1, wherein each thyristor (T11-T14) of the series circuit (RS1) is associated with one of i>1 thyristor groups (T11,T12,T13,T14), each with ni thyristors, wherein all thyristor groups (T11,T12,T13,T14) are being fired temporally successively.

3. The method according to any one of the preceding claims, wherein the number ni of thyristors of all thyristor groups is the same.

4. The method according to any one of the preceding claims, wherein the method is performed repeatedly at a time interval of at least 1 h.

5. The method according to any one of the preceding claims, wherein a piece of information about a firing result is transmitted to a monitoring unit (TVM) and, in the event of a detected malfunction of one of the thyristors, an error message is generated.

6. The method according to any one of the preceding claims, wherein the protective device (1) comprises a further series circuit (RS2) of N thyristors (T21-T24), with the thyristors (T11-T14) of the series circuit (RS1) and the thyristors (T21-T24) of the further series circuit (RS2) being arranged antiparallel to one another.

7. The method according to claim 6, wherein
for checking a firing capability, p<N thyristors of a further thyristor group (T21,T22) of the further series circuit (RS2) are fired when a negative voltage is applied to the further series circuit, and
a positive snubber current (Ibl) flows through the snubber branches (B1,B2) of the thyristors (T21,T22) of the further thyristor group (T21,T22).

8. The method according to any one of the preceding claims, wherein the thyristors (T11-T24) are fired by means of light firing.

9. The method according to any one of the preceding claims, wherein the electrical device (2) is a short-circuit limitation device or a capacitive compensation device.

## Revendications

1. Procédé de surveillance d'un dispositif de protection (1), comportant un montage en série (RS1) de N > 1 thyristors (T11-T14) qui est monté en parallèle à un dispositif électrique à protéger (2), un circuit d'aide à la commutation (B1-B4) étant monté en parallèle à chaque thyristor (T11-T14), dans lequel, aux fins de vérification d'une aptitude à l'amorçage, n < N thyristors (T11, T12) d'un premier groupe de thyristors (T11, T12) sont amorcés lorsqu'une tension positive (Ua) est appliquée au montage en série (RS1), et
un courant de circuit d'aide à la commutation négatif (Ibl) circulant à travers les circuits d'aide à la commutation (B1-B2) des thyristors (T11, T12) du premier groupe de thyristors (T11, T12),
**caractérisé en ce que**
de manière temporellement postérieure à l'amorçage du premier groupe de thyristors (T11, T12), au sein de la même demi-période de tension, m < N thyristors d'un second groupe de thyristors (T13, T14) sont amorcés lorsqu'une tension positive (U2) est appliquée au second groupe de thyristors (T13, T14), et
un courant de circuit d'aide à la commutation négatif (Ib2) circulant à travers les circuits d'aide à la commutation (B3-B4) des thyristors (T13, T14) du second groupe de thyristors (T13, T14), l'amorçage des thyristors du second groupe de thyristors ayant lieu lorsque la tension appliquée au montage en série passe par son zéro.

2. Procédé selon la revendication 1, dans lequel chaque thyristor (T11-T14) du montage en série (RS1) est associé à l'un de i > 1 groupes de thyristors (T11, T12, T13, T14) comprenant chacun ni thyristors, dans lequel tous les groupes de thyristors (T11, T12, T13, T14) sont amorcés de manière temporellement successive.

3. Procédé selon l'une des revendications précédentes, dans lequel le nombre ni de thyristors de tous les groupes de thyristors est identique.

4. Procédé selon l'une des revendications précédentes, dans lequel le procédé est effectué de manière répétée à un intervalle de temps d'au moins 1 h.

5. Procédé selon l'une des revendications précédentes, dans lequel une information concernant un résultat d'amorçage est transmise à une unité de surveillance (TVM) et, en cas de détection d'un dysfonctionnement de l'un des thyristors, un message d'erreur est généré.

6. Procédé selon l'une des revendications précédentes, dans lequel le dispositif de protection (1) comprend un montage en série supplémentaire (RS2) de N thyristors (T21-T24), les thyristors (T11-T14) du montage en série (RS1) et les thyristors (T21-T24) du montage en série supplémentaire (RS2) étant disposés de manière antiparallèle les uns par rapport aux autres.

7. Procédé selon la revendication 6, dans lequel,
aux fins de vérification d'une aptitude à l'amorçage, p < N thyristors d'un groupe de thyristors supplémentaire (T21, T22) du montage en série supplémentaire (RS2) sont amorcés lorsqu'une tension négative est appliquée au montage en série supplémentaire, et
un courant de circuit d'aide à la commutation positif (Ib1) circule à travers les circuits d'aide à la commutation (B1, B2) des thyristors (T21, T22) du groupe de thyristors supplémentaire (T21, T22).

8. Procédé selon l'une des revendications précédentes, dans lequel les thyristors (T11-T24) sont amorcés au moyen d'un amorçage par la lumière.

9. Procédé selon l'une des revendications précédentes, dans lequel le dispositif électrique (2) est un dispositif de limitation de courant de court-circuit ou un dispositif de compensation capacitive.
